# EUROPEAN PATENT SPECIFICATION

(11) **EP 3 840 556 B1**
(45) Date of publication and mention of the grant of the patent: **27.11.2024**
(21) Application number: 19849138.3
(22) Date of filing: 13.08.2019
(51) Int. Cl.: H05K 7/20

(54) **HEAT DISSIPATION STRUCTURE AND ELECTRONIC DEVICE**
WÄRMEABLEITUNGSSTRUKTUR UND ELEKTRONISCHE VORRICHTUNG
STRUCTURE DE DISSIPATION DE CHALEUR ET DISPOSITIF ÉLECTRONIQUE

(30) Priority: 13.08.2018 CN 201810918605
(43) Date of publication of application: 23.06.2021
(73) Proprietor: ZTE Corporation, Shenzhen, Guangdong 518057 (CN)
(72) Inventor: YANG, Bo, Shenzhen, Guangdong 518057 (CN); XIA, Runsheng, Shenzhen, Guangdong 518057 (CN); XU, Zhanbo, Shenzhen, Guangdong 518057 (CN); LIU, Fenglin, Shenzhen, Guangdong 518057 (CN)
(74) Representative: Canzler & Bergmeier Patentanwälte Partnerschaft mbB
(86) International application number: PCT/CN2019/100420
(87) International publication number: WO 2020/034956

(56) References cited:
- WO-A1-2015/047299
- CN-A- 103 163 976
- CN-U- 201 957 383
- CN-U- 206 674 291
- TW-A- 201 400 782
- US-A- 5 018 982

## Description

### TECHNICAL FIELD

The present disclosure relates to the field of heat dissipation technologies, and particularly relates to a heat dissipation structure and an electronic device.

### BACKGROUND

In some cases, when a chip board is prepared, a daughter board is generally stacked on a mother board, and heat dissipation structures are disposed on the daughter board and the mother board respectively to dissipate heat from chips on the daughter board and the mother board. During installation, a connection structure is required to first fix the daughter board on the mother board, and then fix the heat dissipation structures on the mother board and the daughter board respectively, which makes the installation complicated.

TW patent application publication No. TW 201400782A relates to an adjustable heat dissipation device. The heat dissipation device has a heat dissipation base that is provided with a plurality of heat pipes respectively mounted to outer sides of a lower base plate and an upper base plate thereof. The lower base plate has a bottom forming an engaging face that is attachable to a predetermined heat source. The lower base plate is provided with a plurality of regulation holes and a plurality of positioning threaded holes. A plurality of transposition holes is formed in the upper base plate to respectively correspond to the positioning threaded holes. The regulation holes of the lower base plate enable a plurality of adjustment rods of a height adjustment modules that comprises elastic holding members to respectively fit thereon to respectively and movably extend therethrough in such a way that a joining part at one end thereof penetrates through the regulation hole of the lower base plate to adjust the tightness between the lower base plate and the predetermined heat source without causing a gap. Moreover, respectively arranged between the positioning threaded holes of the lower base plate and the transposition holes of the upper base plate is a plurality of transposition rods and elastic holding members of a gap adjustment module. An outer surface of the upper base plate is attached to a heat sink such that the heat dissipation device can rapidly dissipate the heat from the predetermined heat source to the outside.

CN utility model No. CN 201957383U discloses a radiator and equipment with a daughter card architecture, aiming to solve the problem that when a daughter card and a chip of a mother board of the equipment with the daughter card architecture in the prior art share the radiator, the daughter card and a PCB (printed circuit board) of the mother board can deform due to the radiator which is in hardwired connection. The radiator comprises a first substrate and a second substrate which are parallel to each other, and an elastic component is arranged between the first substrate and the second substrate.

When the first substrate approaches the second substrate, the elastic component generates reacting force, the daughter card and the chip on the mother board share the same integral radiator during use, and the chip and a base of the radiator are pressed to contact with each other fully so that hardwired connection cannot be formed and deformation of the PCB is avoided.

### SUMMARY

The features of the heat dissipation structure according to the present invention are defined in the independent claim 1, and the preferable features according to the present invention are defined in the dependent claims.

According to another aspect of the present disclosure, there is provided an electronic device including the heat dissipation structure as described above.

### BRIEF DESCRIPTION OF THE DRAWINGS

FIG. 1 is a structural schematic view of an electronic device and a heat dissipation structure according to an exemplary embodiment of the present disclosure;
FIG. 2 is a partial schematic view showing installation of a heat dissipation structure according to an exemplary embodiment of the present disclosure;
FIG. 3 is an operational schematic view of a heat dissipation structure according to an exemplary embodiment of the present disclosure;
FIG. 4 is a partial structural schematic view of a heat dissipation structure according to an exemplary embodiment of the present disclosure;
FIG. 5 is a side view of a heat dissipation structure according to an exemplary embodiment of the present disclosure;
FIG. 6 is an isometric view of a heat dissipation structure according to an exemplary embodiment of the present disclosure; and
FIG. 7 is a structural schematic view of a substrate mated with a heat dissipation structure according to an exemplary embodiment of the present disclosure.

### DETAILED DESCRIPTION

The present disclosure will be described in further detail below with reference to the drawings and specific embodiments. It should be understood that the specific embodiments described herein are merely for illustration of the disclosure and are not intended to limit the disclosure.

In the description of the exemplary embodiments of the present disclosure, it should be noted that, unless otherwise specified and limited, the term "connection" should be understood broadly, for example, including an electrical connection, an internal communication between two elements, a direct connection, or an indirect connection via an intermediate medium, and a specific meaning of the term may be understood by those of ordinary skill in the art according to the specific situation.

It should be noted that the terms "first\second\third" related to the exemplary embodiments of the present disclosure are only used for distinguishing similar objects and do not represent a specific ordering for the objects, and it should be understood that "first\second\third" may be interchangeable in a specific order or sequence when allowed. It should be understood that the objects identified as "first\second\third" may be interchangeable under appropriate circumstances such that the exemplary embodiments of the disclosure described herein may be implemented in an order other than those illustrated or described herein.

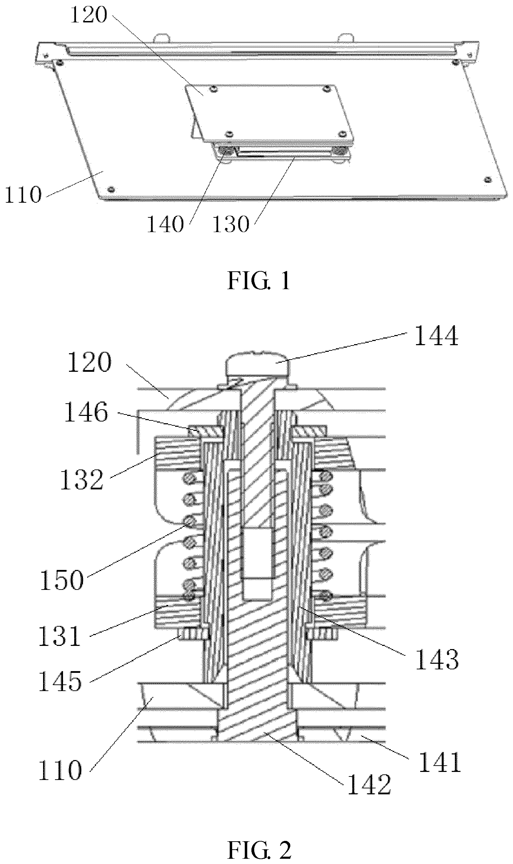

The heat dissipation structure according to the exemplary embodiments of the present disclosure will be described in detail below with reference to FIGs. 1 to 7.

As shown in FIG. 1, an exemplary embodiment of the present disclosure provides an electronic device and a heat dissipation structure. The heat dissipation structure includes a first body 110, a second body 120, a heat dissipation member 130 and a connection member 140. A first end of the connection member 140 is fixedly connected to the first body 110, and a second end of the connection member 140 is fixedly connected to the second body 120. The heat dissipation member 130 is disposed in the middle of the connection member 140, and is located between the first body 110 and the second body 120. Each one of the first body 110 and the second body 120 has a distance, which is within a preset distance range, from the heat dissipation member 130; or, a preset distance is provided between the heat dissipation member 130 and each one of the first body 110 and the second body 120.

In an exemplary embodiment of the present disclosure, shapes of the first body 110 and the second body 120 are not limited. Each of the first body 110 and the second body 120 exemplarily shown in FIG. 1 has a plate-like structure.

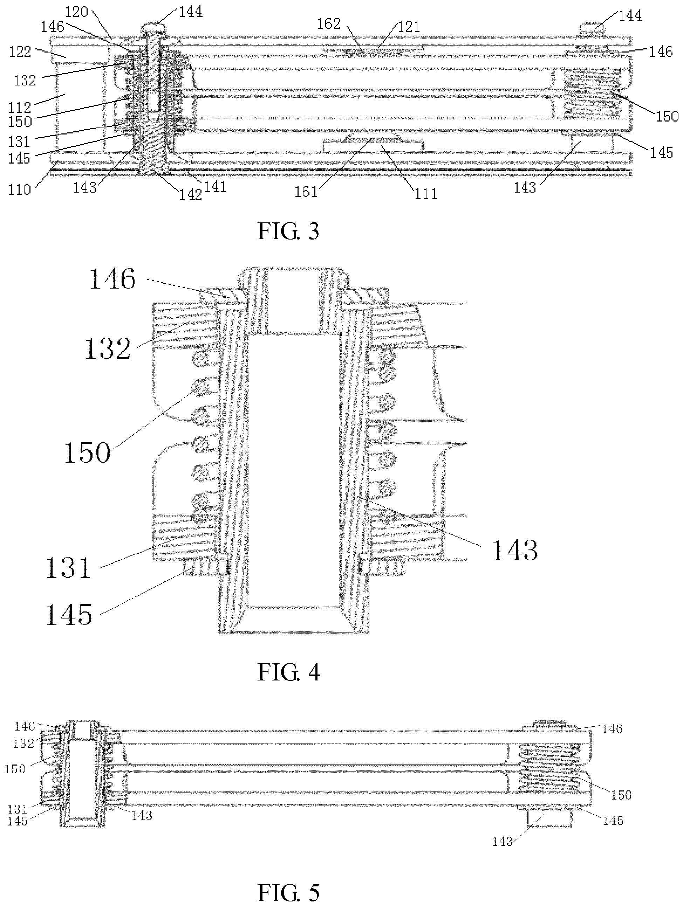

Here, the first body 110 and the second body 120 are only broadly referred to and do not particularly limit which part thereof is. For example, as shown in FIG. 3, the first body 110 may be a mother board, which may include a Printed Circuit Board (PCB) and a mother board chip 111. For another example, the second body 120 may be a daughter board, which may include a PCB board and a daughter board chip 121.

In an exemplary embodiment of the present disclosure, the structure of the connection member 140 is not limited, as long as the connection member 140 has a first end fixedly connected to the first body 110 and a second end fixedly connected to the second body 120; and the heat dissipation member 130 is disposed in the middle of the connection member 140. For example, the connection member 140 may include a bolt and a nut, via which the first body 110 and the second body 120 are fixedly connected, and the heat dissipation member 130 is disposed in the middle of the bolt.

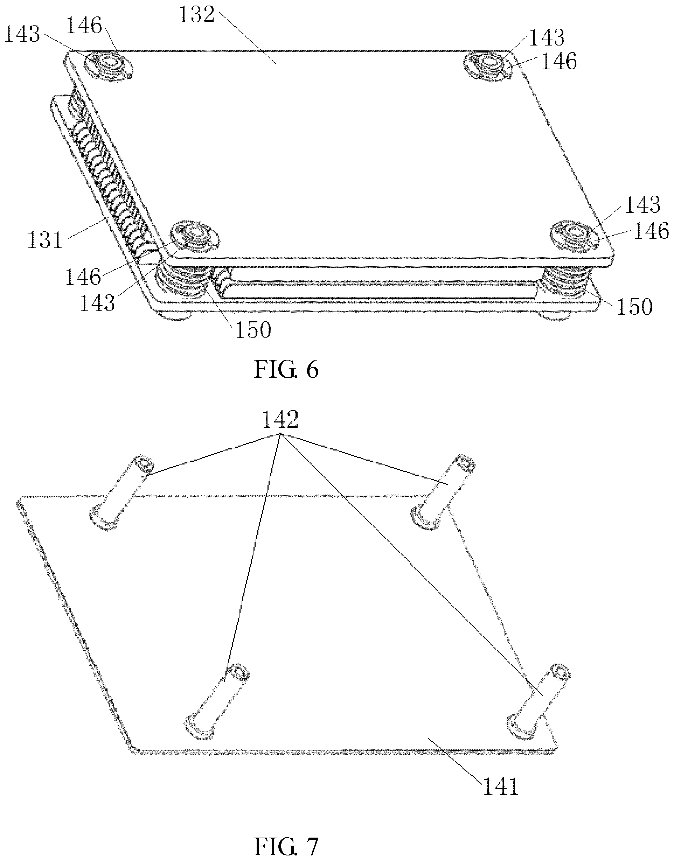

Here, the number of the connection members 140 is not limited, and FIGs. 1 and 6 exemplarily show four connection members 140.

In an exemplary embodiment of the present disclosure, the heat dissipation member 130 is used for dissipating heat from at least one of the first body 110 and the second body 120, and the specific structure thereof is not limited as long as each one of the first body 110 and the second body 120 has a distance, which is within a preset distance range, from the heat dissipation member 130; or, a preset distance is provided between the heat dissipation member 130 and each one of the first body 110 and the second body 120.

Those of ordinary skill in the art may set the preset distance according to actual needs, as long as the preset distance satisfies the condition that the heat dissipation member 130 can dissipate heat from at least one of the first body 110 and the second body 120. Here, it should be understood that, the heat dissipation member 130 is disposed in the middle of the connection member 140. Those of ordinary skill in the art may set the preset distance range according to actual needs, as long as the preset distance range satisfies the condition that the heat dissipation member 130 can dissipate heat from at least one of the first body 110 and the second body 120. Here, it should be understood that, the heat dissipation member 130 is movable in the middle of the connection member 140, such that each one of the first body 110 and the second body 120 has a distance, which is within a preset distance range, from the heat dissipation member 130.

In some implementations of the present disclosure, in order to enable the heat dissipation member 130 to better dissipate heat from at least one of the first body 110 and the second body 120, a heat-conducting medium is disposed between the heat dissipation member 130 and at least one of the first body 110 and the second body 120, via which heat can be better transferred, thereby improving the heat dissipation efficiency.

For example, when at least one of the first body 110 and the second body 120 has a distance, which is within the preset distance range, from the heat dissipation member 130, the heat dissipation structure may further include a third heat-conducting medium which has one end abutting against the heat dissipation member 130 and the other end abutting against at least one of the first body 110 and the second body 120; and the heat generated from at least one of the first body 110 and the second body 120 can be carried away more rapidly by the heat dissipation member 130 via the third heat-conducting medium.

Here, the heat dissipation member 130 is movable in the middle of the connection member 140, and can absorb a dimensional cumulative error generated during production and assembly of the heat dissipation structure, such that the third heat-conducting medium has one end abutting against the heat dissipation member 130 and the other end abutting against at least one of the first body 110 and the second body 120. Here, the third heat-conducting medium may be set to be thinner, and according to the calculation formula of thermal resistance, the thinner the heat-conducting medium is, the smaller the thermal resistance is, and the more heat can be transferred.

Here, the third heat-conducting medium may have a thickness equal to or slightly greater than a preset minimum thickness, that is, 0 mm. As an example, the third heat-conducting medium has a thickness less than or equal to 0.4 mm. Here, the third heat-conducting medium may be heat-conducting silicone grease.

For another example, when a preset distance is provided between the heat dissipation member 130 and at least one of the first body 110 and the second body 120, the heat dissipation structure may further include a fourth heat-conducting medium which has one end abutting against the heat dissipation member 130 and the other end abutting against at least one of the first body 110 and the second body 120. The fourth heat-conducting medium is elastic and has a thickness greater than the third heat-conducting medium. The heat generated from at least one of the first body 110 and the second body 120 can be carried away more rapidly by the heat dissipation member 130 via the fourth heat-conducting medium.

Here, the heat dissipation member 130 is fixedly disposed in the middle of the connection member 140, and due to the elasticity, the fourth heat-conducting medium can absorb a dimensional cumulative error generated during production and assembly of the heat dissipation structure, such that the fourth heat-conducting medium has one end abutting against the heat dissipation member 130 and the other end abutting against at least one of the first body 110 and the second body 120. Here, the fourth heat-conducting medium may be set to be thicker, so as to absorb the dimensional cumulative error generated during production and assembly of the heat dissipation structure.

Here, the fourth heat-conducting medium may have a thickness much greater than the preset minimum thickness. As an example, the fourth heat-conducting medium has a thickness in the range of 0.5 mm to 6.35 mm. Here, the fourth heat-conducting medium may be a heat-conducting pad or an ultra-flexible heat-conducting pad. As another example, the fourth heat-conducting medium has a thickness in the range of 1.5 mm to 2.5 mm. Here, the fourth heat-conducting medium may be an efficient heat-conducting pad.

In some examples not covered by the claims, the heat dissipation member 130 is fixedly disposed in the middle of the connection member 140; and the preset distance is provided between the heat dissipation member 130 and at least one of the first body 110 and the second body 120.

Here, the heat dissipation member 130 may have the preset distance from the first body 110; or may have the preset distance from the second body 120, or may have the preset distance from the first body 110 as well as from the second body 120.

Here, the fixing manner of the heat dissipation member 130 is not limited.

In some implementations of the present disclosure, the heat dissipation structure includes an elastic member 150. The elastic member 150 and the heat dissipation member 130 are both sleeved in the middle of the connection member 140, and the elastic member 150 abuts against the heat dissipation member 130. The heat dissipation member 130 is movable along the connection member 140 via deformation of the elastic member 150, and each one of the first body 110 and the second body 120 has a distance, which is within the preset distance range, from the heat dissipation member 130.

Here, via deformation of the elastic member 150, the heat dissipation member 130 has the preset distance range from the first body 110 as well as from the second body 120.

As an example, a first end of the elastic member 150 abuts against a first end of the heat dissipation member 130; and a second end of the elastic member 150 may be fixedly disposed on the connection member 140. Via deformation of the elastic member 150, a second end of the heat dissipation member 130 has the preset distance range from the first body 110, in which case the second end of the heat dissipation member 130 is located on the side of the first body 110; or, via deformation of the elastic member 150, the second end of the heat dissipation member 130 has the preset distance range from the second body 120, in which case the second end of the heat dissipation member 130 is located on the side of the second body 120.

As another example, the heat dissipation member 130 includes two parts. The first end of the elastic member 150 abuts against one part of the heat dissipation member 130; and the second end of the elastic member 150 abuts against the other part of the heat dissipation member 130. One part of the heat dissipation member 130 is located on the side of the first body 110, and the other part of the heat dissipation member 130 is located on the side of the second body 120. Via deformation of the elastic member 150, one part of the heat dissipation member 130 has the preset distance range from the first body 110; and via deformation of the elastic member 150, the other part of the heat dissipation member 130 has the preset distance range from the second body 120.

Here, those of ordinary skill in the art may set the shape and the structure of the elastic member 150 according to actual needs, as long as the elastic member 150 is elastic. For example, the elastic member 150 may be made of an elastic material. As an example, the elastic member 150 may be made of a rubber material. For another example, the elastic member 150 may have an elastic structure. As an example, the elastic member 150 may be a spring.

In some implementations of the present disclosure, the heat dissipation member 130 includes a first heat sink 131 and a second heat sink 132. The first heat sink 131 is disposed in the middle of the connection member 140, and located on the side of the first body 110 for dissipating heat from the first body 110. The second heat sink 132 is disposed in the middle of the connection member 140, and located on the side of the second body 120 for dissipating heat from the second body 120.

In an exemplary embodiment of the present disclosure, the first heat sink 131 is disposed movable with respect to the connection member 140. The second heat sink 132 is disposed movable with respect to the connection member 140. Three arrangements of the first heat sink 131 and the second heat sink 132 are exemplarily listed below.

In a first arrangement of the first heat sink 131 and the second heat sink 132, as shown in FIGs. 2 to 6, the heat dissipation structure further includes an elastic member 150. The elastic member 150, the first heat sink 131 and the second heat sink 132 are all sleeved in the middle of the connection member 140, and the elastic member 150 abuts against each of the first heat sink 131 and the second heat sink 132. The first heat sink 131 is fixed in position with respect to one end of the elastic member 150, and the second heat sink 132 is fixed in position with respect to the other end of the elastic member 150. The first heat sink 131 is movable along the connection member 140 via deformation of the elastic member 150, and the first heat sink 131 has a distance, which is within the first preset distance range, from the first body 110. The second heat sink 132 is movable along the connection member 140 via deformation of the elastic member 150, and the second heat sink 132 has a distance, which is within the second preset distance range, from the second body 120.

Here, the first heat sink 131 is movable with respect to the first body 110, so that the first heat sink 131 can dissipate heat more flexibly from the first body 110. The second heat sink 132 is movable with respect to the second body 120, so that the second heat sink 132 can dissipate heat more flexibly from the second body 120.

Here, the first preset distance range and the second preset distance range are similar to the preset distance ranges described above, and reference may be made thereto. The first preset distance range satisfies a condition that the first heat sink 131 can dissipate heat from the first body 110. The second preset distance range satisfies a condition that the second heat sink 132 can dissipate heat from the second body 120.

The elastic member 150 has been described above, and will not be detailed here.

Here, since the first heat sink 131 is fixed in position with respect to one end of the elastic member 150, and the second heat sink 132 is fixed in position with respect to the other end of the elastic member 150, it is realized that the elastic member 150 abuts against each of the first heat sink 131 and the second heat sink 132, and positions of the first heat sink 131, the elastic member 150 and the second heat sink 132 between the first body 110 and the second body 120 are defined.

Here, the manner for fixing the relative positions of the first heat sink 131 and one end of the elastic member 150 is not limited, and the manner for fixing the relative positions of the second heat sink 132 and the other end of the elastic member 150 is not limited. This may be achieved, for example, by providing another elastic structure.

Here, the elastic member 150 has a natural (undeformed) state or a pressed (deformed) state, and is pressed to be deformed when the first heat sink 131 or the second heat sink 132 is moved. It should be understood by those of ordinary skill in the art that when the first heat sink 131 is moved, the first heat sink 131 is fixed in position with respect to one end of the elastic member 150, and when the second heat sink 132 is moved, the second heat sink 132 is fixed in position with respect to the other end of the elastic member 150.

In some implementations of the present disclosure, to facilitate heat dissipation, the heat dissipation structure may further include a first heat-conducting medium 161 and a second heat-conducting medium 162. The first heat-conducting medium 161 has one end abutting against the first heat sink 131 and the other end abutting against the first body 110. The second heat-conducting medium 162 has one end abutting against the second heat sink 132 and the other end abutting against the second body 120. Each of the first heat-conducting medium 161 and the second heat-conducting medium 162 has a thickness slightly greater than the preset minimum thickness.

Here, the first heat sink 131 is movable with respect to the first body 110, and can absorb a dimensional cumulative error generated during production and assembly of the heat dissipation structure, such that the first heat-conducting medium has one end abutting against the first heat sink 131 and the other end abutting against the first body 110. Here, the first heat-conducting medium may be set to be thinner, and according to the calculation formula of thermal resistance, the thinner the heat-conducting medium is, the smaller the thermal resistance is, the more heat can be transferred, and the more powerful the heat dissipation structure is.

Here, the second heat sink 132 is also movable with respect to the second body 120, and can absorb a dimensional cumulative error generated during production and assembly of the heat dissipation structure, such that the second heat-conducting medium has one end abutting against the second heat sink 132 and the other end abutting against the second body 120. Here, the second heat-conducting medium may also be set to be thinner, and according to the calculation formula of thermal resistance, the thinner the heat-conducting medium is, the smaller the thermal resistance is, the more heat can be transferred, and the more powerful the heat dissipation structure is.

Here, the first heat sink 131 and the second heat sink 132 are both movable, can absorb a dimensional cumulative error generated during production and assembly of the heat dissipation structure, and dissipate heat from the first body 110 and the second body 120, respectively, with a more powerful heat dissipation capability, simpler structure and simpler installation operation.

The preset thickness has already been described above, and will not be detailed here.

Here, the first heat-conducting medium 161 and the second heat-conducting medium 162 are similar to the third heat-conducting medium described above, and reference may be made thereto.

Here, a limiting mechanism may be disposed in the middle of the connection member 140. When the first heat-conducting medium 161 and the second heat-conducting medium 162 are not installed, it is realized by the limiting mechanism that the first heat sink 131 is fixed in position with respect to one end of the elastic member 150, and the second heat sink 132 is fixed in position with respect to the other end of the elastic member 150. When the first heat-conducting medium 161 and the second heat-conducting medium 162 are installed, it is realized by the first heat-conducting medium 161 that the first heat sink 131 is fixed in position with respect to one end of the elastic member 150, and realized by the second heat-conducting medium 162 that the second heat sink 132 is fixed in position with respect to the other end of the elastic member 150.

Here, referring to FIG. 3, the first body 110 may be a mother board, which may include a PCB board and a mother board chip 111 (as an example of a first chip). The second body 120 may be a daughter board, which may include a PCB board and a daughter board chip 121 (as an example of a second chip). In this case, in order to facilitate cooling of the mother board chip 111 and the daughter board chip 121, the first heat-conducting medium 161 may be disposed between the mother board chip 111 and the first heat sink 131, and the second heat-conducting medium 162 may be disposed between the daughter board chip 121 and the second heat sink 132.

In some implementations of the present disclosure, as shown in FIGs. 2 to 6, the connection member 140 may include a connection post 142, a sleeve 143, and a fixing post 144. The first body 110 is provided with a first through hole matched with a shape of the connection post 142, and the second body 120 is provided with a second through hole matched with a shape of the fixing post 144. The connection post 142 passes through the first through hole such that a head end of the connection post 142 abuts against an outer side face of the first body 110. The sleeve 143 is sleeved on an outer side of a tail end of the connection post 142 and abuts against an inner side face of the first body 110 and an inner side face of the second body 120, respectively. The first heat sink 131, the elastic member 150 and the second heat sink 132 are sleeved on an outer side of the sleeve 143. The fixing post 144 has a head end abutting against the outer side face of the second body 120, and a tail end passing through the second through hole and an opening of the sleeve 143 to be fixedly connected to the connection post 142.

Here, as shown in FIGs. 2 and 3, the first body 110 and the second body 120 being relatively fixed in position is realized by the head end of the connection post 142 abutting against the outer side face of the first body 110, the head end of the fixing post 144 abutting against the outer side face of the second body 120, and the sleeve 143 abutting against an inner side face of the first body 110 and an inner side face of the second body 120 respectively.

Here, the manner for fixing the relative positions of the first heat sink 131 and one end of the elastic member 150 is not limited. The heat dissipation structure exemplarily shown in FIGs. 2 to 6 may further include a first opening collar 145 (as an example positioning member) positioned on the outer side of the sleeve 143 and abutting against an end of the first heat sink 131 away from the elastic member 150. When the first heat-conducting medium 161 is disposed between the first heat sink 131 and the first body 110, the first heat-conducting medium 161 abuts against the first heat sink 131.

Here, the manner for fixing the relative positions of the second heat sink 132 and the other end of the elastic member 150 is not limited. The heat dissipation structure exemplarily shown in FIGs. 2 to 6 may further include a second opening collar 146 (as an example positioning member) positioned on the outer side of the sleeve 143 and abutting against the other end of the second heat sink 132 away from the elastic member 150. When the second heat-conducting medium 162 is disposed between the second heat sink 132 and the second body 120, the second heat-conducting medium 162 abuts against the second heat sink 132.

Here, as shown in FIGs. 1 and 6, when the first body 110 and the second body 120 are fixedly connected by four sets of connection posts 142, sleeves 143, and fixing posts 144, the four connection posts 142 may be disposed on one structure, as shown in FIG. 7, and the heat dissipation structure may further include a substrate 141 on which the four connection posts 142 are disposed. Here, during assembly of the heat dissipation structure, the first heat sink 131, the second heat sink 132 and the four elastic members 150 may be first mounted on the four sleeves 143 to form an integral heat dissipation structure, as shown in FIGs. 4 to 6. Then, the first body 110, the integral heat dissipation structure and the second body 120 are sequentially sleeved on the four connection posts 142 of the substrate 141. Finally, the four connection posts 142 are respectively and fixedly connected via the four fixing posts 144. Here, the four connection posts 142 of the substrate 141 are assembled at the same time, which makes the assembly simple and the installation efficient.

For another example not covered by the claims, the first heat sink 131 is fixedly disposed in the middle of the connection member 140, and the first heat sink 131 has the first preset distance from the first body 110; and the second heat sink 132 is fixedly disposed in the middle 140 of the connection member, and the second heat sink 132 has the second preset distance from the second body 120.

Here, the first preset distance and the second preset distance are similar to the preset distance described above, and reference may be made thereto. The first preset distance satisfies a condition that the first heat sink 131 can dissipate heat from the first body 110. The second preset distance satisfies a condition that the second heat sink 132 can dissipate heat from the second body 120.

Here, to facilitate heat dissipation, a fifth heat-conducting medium may be disposed between the first heat sink 131 and the first body 110, and a sixth heat-conducting medium may be disposed between the second heat sink 132 and the second body 120.

Here, the fifth and sixth heat-conducting media are similar to the fourth heat-conducting medium described above, and reference may be made thereto.

For another example not covered by the claims, in a third arrangement of the first heat sink 131 and the second heat sink 132, the heat dissipation structure further includes an elastic member 150. The first heat sink 131 is fixedly disposed in the middle of the connection member 140, and the first heat sink 131 has the first preset distance from the first body 110. The second heat sink 132 and the elastic member 150 are both sleeved in the middle of the connection member 140, and the elastic member 150 has a first end abuts against the second heat sink 132 and a second end fixedly disposed. The second heat sink 132 is movable along the connection member 140 via deformation of the elastic member 150, and the second heat sink 132 has a distance, which is within the second preset distance range, from the second body 120.

The elastic member 150, the first preset distance range and the second preset distance range have been described above, and will not be detailed here.

Here, to facilitate heat dissipation, a fifth heat-conducting medium may be disposed between the first heat sink 131 and the first body 110, and a second heat-conducting medium 162 may be disposed between the second heat sink 132 and the second body 120.

The fifth heat-conducting medium and the second heat-conducting medium 162 have already been described above, and will not be detailed here.

Here, it should be understood by those of ordinary skill in the art that the second heat sink 132 may be fixedly disposed, and the first heat sink 131 may be disposed movable, which is specifically implemented in a manner similar to the aforementioned third arrangement of the first heat sink 131 and the second heat sink 132, and reference may be made thereto.

In some implementations of the present disclosure, as shown in FIG. 3, the heat dissipation structure may further include: a socket 112 disposed at an inner side of the first body 110, and a plug 122 disposed at an inner side of the second body 120. The plug 122 is inserted into the socket 112 such that the first body 110 and the second body 120 are electrically connected, so as to perform information interaction between the first body 110 and the second body 120.

In an exemplary embodiment of the present disclosure, the heat dissipation member 130 is disposed in the middle of the connection member 140, and while the connection member 140 is fixedly connected to the first body 110 and the second body 120, heat from at least one of the first body 110 and the second body 120 may be dissipated via the heat dissipation member 130, which is simple in structure and easy to install and operate, thereby improving installation efficiency, reducing the number of mounting holes formed in the first body 110 and the second body 120, and increasing space utilization of the first body 110 and the second body 120.

The present disclosure also provides an electronic device including the heat dissipation structure described in the above exemplary embodiments.

Here, the electronic device may be a mobile phone, a computer, a game machine, a laptop, or the like.

The foregoing are merely specific implementations of the present disclosure, but the protection scope of the disclosure is not limited thereto. Any modification or alternative that can be easily conceived by those skilled in the art within the technical scope disclosed by the disclosure shall fall in the protection scope of the disclosure. Therefore, the protection scope of the present disclosure shall be defined by the scope of the claims.

## Claims

1. A heat dissipation structure, comprising: a first body (110), a second body (120), a heat dissipation member (130) and a connection member (140), wherein
a first end of the connection member (140) is fixedly connected to the first body (110), a second end of the connection member (140) is fixedly connected to the second body (120), and the heat dissipation member (130) is disposed in the middle of the connection member (140) along a length direction of the connection member (140) and is located between the first body (110) and the second body (120),
the heat dissipation member (130) comprises a first heat sink (131) and a second heat sink (132);
the first heat sink (131) is located on a side of the first body (110);
the second heat sink (132) is located on a side of the second body (120), and
the heat dissipation structure further comprises an elastic member (150),
**characterized in that**,
the elastic member (150), the first heat sink (131) and the second heat sink (132) are all sleeved in the middle of the connection member (140), the elastic member (150) is configured to abut against each of the first heat sink (131) and the second heat sink (132), the first heat sink (131) is fixed in position with respect to one end of the elastic member (150), and the second heat sink (132) is fixed in position with respect to another end of the elastic member (150),
the first heat sink (131) is movable along the connection member (140) via deformation of the elastic member (150), and the first heat sink (131) has a distance, which is within a first preset distance range, from the first body (110), and
the second heat sink (132) is movable along the connection member (140) via deformation of the elastic member (150), and the second heat sink (132) has a distance, which is within a second preset distance range, from the second body (120).

2. The heat dissipation structure according to claim 1, further comprising a first heat-conducting medium (161) and a second heat-conducting medium (162), wherein
the first heat-conducting medium (161) has one end abutting against the first heat sink (131) and another end abutting against the first body (110),
the second heat-conducting medium (162) has one end abutting against the second heat sink (132) and another end abutting against the second body (120), and
each of the first heat-conducting medium (161) and the second heat-conducting medium (162) has a thickness greater than a preset minimum thickness.

3. The heat dissipation structure according to claim 1, wherein the connection member (140) comprises a connection post (142), a sleeve (143) and a fixing post (144),
the first body (110) is provided with a first through hole matched with a shape of the connection post (142), the second body (120) is provided with a second through hole matched with a shape of the fixing post (144), and
the connection post (142) is configured to pass through the first through hole such that a head end of the connection post (142) is configured to abut against an outer side face of the first body (110), the sleeve (143) is sleeved on an outer side of a tail end of the connection post (142) and is configured to abut against an inner side face of the first body (110) and an inner side face of the second body (120) respectively, the first heat sink (131), the elastic member (150) and the second heat sink (132) are sleeved on an outer side of the sleeve (143), and the fixing post (144) has a head end abutting against the outer side face of the second body (120), and a tail end passing through the second through hole and an opening of the sleeve (143) to be fixedly connected to the connection post (142).

4. The heat dissipation structure according to claim 3, wherein the connection member (140) further comprises a positioning member,
the positioning member is fitted on the sleeve (143) such that the first heat sink (131) and the second heat sink (132) abut against the positioning member under an action of the elastic member (150).

5. The heat dissipation structure according to claim 2, wherein the first body (110) has a first chip protrudingly disposed, the first heat-conducting medium (161) being disposed between the first heat sink (131) and the first chip, and the second body (120) has a second chip protrudingly disposed, the second heat-conducting medium (162) being disposed between the second heat sink (132) and the second chip.

6. The heat dissipation structure according to claim 1, further comprising a socket (112) and a plug (122), wherein
the socket (112) is disposed at an inner side of the first body (110), the plug (122) is disposed at an inner side of the second body (120), and the plug (122) is inserted into the socket (112) such that the first body (110) and the second body (120) are electrically connected.

7. An electronic device, comprising the heat dissipation structure according to any one of claims 1 to 6.

## Patentansprüche

1. Wärmeableitungsstruktur, umfassend: einen ersten Körper (110), einen zweiten Körper (120), ein Wärmeableitungselement (130) und ein Verbindungselement (140), wobei
ein erstes Ende des Verbindungselements (140) fest mit dem ersten Körper (110) verbunden ist, ein zweites Ende des Verbindungselements (140) fest mit dem zweiten Körper (120) verbunden ist und das Wärmeableitungselement (130) in der Mitte des Verbindungselements (140) entlang einer Längsrichtung des Verbindungselements (140) angeordnet ist und sich zwischen dem ersten Körper (110) und dem zweiten Körper (120) befindet,
das Wärmeableitungselement (130) eine erste Wärmesenke (131) und eine zweite Wärmesenke (132) umfasst;
die erste Wärmesenke (131) sich auf einer Seite des ersten Körpers (110) befindet;
die zweite Wärmesenke (132) sich auf einer Seite des zweiten Körpers (120) befindet und
die Wärmeableitungsstruktur ferner ein elastisches Element (150) umfasst,
**dadurch gekennzeichnet, dass** das elastische Element (150), die erste Wärmesenke (131) und die zweite Wärmesenke (132) alle in der Mitte des Verbindungselements (140) ummantelt sind, das elastische Element (150) so konfiguriert ist, dass es sowohl an der ersten Wärmesenke (131) als auch an der zweiten Wärmesenke (132) anliegt, die erste Wärmesenke (131) in Bezug auf ein Ende des elastischen Elements (150) in Position fixiert ist und die zweite Wärmesenke (132) in Bezug auf ein anderes Ende des elastischen Elements (150) in Position fixiert ist,
die erste Wärmesenke (131) entlang des Verbindungselements (140) durch Verformung des elastischen Elements (150) beweglich ist und die erste Wärmesenke (131) einen Abstand von dem ersten Körper (110) aufweist, der innerhalb eines ersten voreingestellten Abstandsbereichs liegt, und
die zweite Wärmesenke (132) entlang des Verbindungselements (140) durch Verformung des elastischen Elements (150) beweglich ist und die zweite Wärmesenke (132) einen Abstand von dem zweiten Körper (120) aufweist, der innerhalb eines zweiten voreingestellten Abstandsbereichs liegt.

2. Wärmeableitungsstruktur nach Anspruch 1, ferner umfassend ein erstes wärmeleitendes Medium (161) und ein zweites wärmeleitendes Medium (162), wobei
das erste wärmeleitende Medium (161) ein Ende aufweist, das an der ersten Wärmesenke (131) anliegt, und ein anderes Ende, das an dem ersten Körper (110) anliegt,
das zweite wärmeleitende Medium (162) ein Ende aufweist, das an der zweiten Wärmesenke (132) anliegt, und ein anderes Ende, das an dem zweiten Körper (120) anliegt, und
das erste wärmeleitende Medium (161) und das zweite wärmeleitende Medium (162) jeweils eine Dicke aufweisen, die größer als eine voreingestellte Mindestdicke ist.

3. Wärmeableitungsstruktur nach Anspruch 1, wobei das Verbindungselement (140) einen Verbindungspfosten (142), eine Hülse (143) und einen Befestigungspfosten (144) umfasst,
der erste Körper (110) mit einem ersten Durchgangsloch versehen ist, das mit einer Form des Verbindungspfostens (142) zusammenpasst, der zweite Körper (120) mit einem zweiten Durchgangsloch versehen ist, das mit einer Form des Befestigungspfostens (144) zusammenpasst, und
der Verbindungspfosten (142) so konfiguriert ist, dass er durch das erste Durchgangsloch verläuft, so dass ein Kopfende des Verbindungspfostens (142) so konfiguriert ist, dass es an einer Außenseitenfläche des ersten Körpers (110) anliegt, die Hülse (143) an einer Außenseite eines hinteren Endes des Verbindungspfostens (142) ummantelt ist und so konfiguriert ist, dass sie an einer Innenseitenfläche des ersten Körpers (110) bzw. einer Innenseitenfläche des zweiten Körpers (120) anliegt, die erste Wärmesenke (131), das elastische Element (150) und die zweite Wärmesenke (132) an einer Außenseite der Hülse (143) ummantelt sind und der Befestigungspfosten (144) ein Kopfende, das an der Außenseitenfläche des zweiten Körpers (120) anliegt, und ein hinteres Ende aufweist, das durch das zweite Durchgangsloch und eine Öffnung der Hülse (143) verläuft, um fest mit dem Verbindungspfosten (142) verbunden zu werden.

4. Wärmeableitungsstruktur nach Anspruch 3, wobei das Verbindungselement (140) ferner ein Positionierungselement umfasst,
das Positionierungselement so an der Hülse (143) angebracht ist, dass die erste Wärmesenke (131) und die zweite Wärmesenke (132) unter einer Wirkung des elastischen Elements (150) an dem Positionierungselement anliegen.

5. Wärmeableitungsstruktur nach Anspruch 2, wobei der erste Körper (110) einen ersten Chip aufweist, der vorstehend angeordnet ist, das erste wärmeleitende Medium (161) zwischen der ersten Wärmesenke (131) und dem ersten Chip angeordnet ist und der zweite Körper (120) einen zweiten Chip aufweist, der vorstehend angeordnet ist, das zweite wärmeleitende Medium (162) zwischen der zweiten Wärmesenke (132) und dem zweiten Chip angeordnet ist.

6. Wärmeableitungsstruktur nach Anspruch 1, ferner umfassend eine Buchse (112) und einen Stecker (122), wobei
die Buchse (112) an einer Innenseite des ersten Körpers (110) angeordnet ist, der Stecker (122) an einer Innenseite des zweiten Körpers (120) angeordnet ist und der Stecker (122) so in die Buchse (112) eingeführt ist, dass der erste Körper (110) und der zweite Körper (120) elektrisch verbunden sind.

7. Elektronisches Gerät, umfassend die Wärmeableitungsstruktur nach einem der Ansprüche 1 bis 6.

## Revendications

1. Structure de dissipation de chaleur, comprenant : un premier corps (110), un second corps (120), un élément de dissipation de chaleur (130) et un élément de connexion (140), dans laquelle
une première extrémité de l'élément de connexion (140) est connectée de manière fixe au premier corps (110), une seconde extrémité de l'élément de connexion (140) est connectée de manière fixe au second corps (120), et l'élément de dissipation de chaleur (130) est disposé au milieu de l'élément de connexion (140) le long d'une direction de longueur de l'élément de connexion (140) et est situé entre le premier corps (110) et le second corps (120),
l'élément de dissipation de chaleur (130) comprend un premier dissipateur thermique (131) et un second dissipateur thermique (132) ;
le premier dissipateur thermique (131) est situé sur un côté du premier corps (110) ;
le second dissipateur thermique (132) est situé sur un côté du second corps (120), et
la structure de dissipation de chaleur comprend en outre un élément élastique (150),
**caractérisée en ce que** l'élément élastique (150), le premier dissipateur thermique (131) et le second dissipateur thermique (132) sont tous gainés au milieu de l'élément de connexion (140), l'élément élastique (150) est configuré pour venir en butée contre chacun du premier dissipateur thermique (131) et du second dissipateur thermique (132), le premier dissipateur thermique (131) est fixé en position par rapport à une extrémité de l'élément élastique (150), et le second dissipateur thermique (132) est fixé en position par rapport à une autre extrémité de l'élément élastique (150),
le premier dissipateur thermique (131) est mobile le long de l'élément de connexion (140) par déformation de l'élément élastique (150), et le premier dissipateur thermique (131) a une distance, qui est dans une première plage de distance prédéfinie, par rapport au premier corps (110), et
le second dissipateur thermique (132) est mobile le long de l'élément de connexion (140) par déformation de l'élément élastique (150), et le second dissipateur thermique (132) a une distance, qui est dans une seconde plage de distance prédéfinie, par rapport au second corps (120).

2. Structure de dissipation de chaleur selon la revendication 1, comprenant en outre un premier medium de conducteur de chaleur (161) et un second medium de conducteur de chaleur (162), dans laquelle
le premier medium de conducteur de chaleur (161) a une extrémité venant en butée contre le premier dissipateur thermique (131) et une autre extrémité venant en butée contre le premier corps (110),
le second medium de conducteur de chaleur (162) a une extrémité venant en butée contre le second dissipateur thermique (132) et une autre extrémité venant en butée contre le second corps (120), et
chacun du premier medium de conducteur de chaleur (161) et du second medium de conducteur de chaleur (162) a une épaisseur supérieure à une épaisseur minimale prédéfinie.

3. Structure de dissipation de chaleur selon la revendication 1, dans laquelle l'élément de connexion (140) comprend un montant de connexion (142), un manchon (143) et un montant de fixation (144),
le premier corps (110) est pourvu d'un premier trou d'interconnexion adapté à une forme du montant de connexion (142), le second corps (120) est pourvu d'un second trou d'interconnexion adapté à une forme du montant de fixation (144), et
le montant de connexion (142) est configuré pour passer à travers le premier trou d'interconnexion de sorte qu'une extrémité de tête du montant de connexion (142) est configurée pour venir en butée contre une face latérale externe du premier corps (110), le manchon (143) est gainé sur un côté externe d'une extrémité de queue du montant de connexion (142) et est configuré pour venir en butée contre une face latérale interne du premier corps (110) et une face latérale interne du second corps (120) respectivement, le premier dissipateur thermique (131), l'élément élastique (150) et le second dissipateur thermique (132) sont gainés sur un côté externe du manchon (143), et le montant de fixation (144) a une extrémité de tête venant en butée contre la face latérale externe du second corps (120), et une extrémité de queue passant à travers le second trou d'interconnexion et une ouverture du manchon (143) pour être connectée de manière fixe au montant de connexion (142).

4. Structure de dissipation de chaleur selon la revendication 3, dans laquelle l'élément de connexion (140) comprend en outre un élément de positionnement,
l'élément de positionnement est monté sur le manchon (143) de sorte que le premier dissipateur thermique (131) et le second dissipateur thermique (132) viennent en butée contre l'élément de positionnement sous une action de l'élément élastique (150).

5. Structure de dissipation de chaleur selon la revendication 2, dans laquelle le premier corps (110) a une première puce disposée de manière saillante, le premier medium de conducteur de chaleur (161) étant disposé entre le premier dissipateur thermique (131) et la première puce, et le second corps (120) a une seconde puce disposée de manière saillante, le second medium de conducteur de chaleur (162) étant disposé entre le second dissipateur thermique (132) et la seconde puce.

6. Structure de dissipation de chaleur selon la revendication 1, comprenant en outre une prise (112) et une fiche (122), dans laquelle
la prise (112) est disposée au niveau d'un côté intérieur du premier corps (110), la fiche (122) est disposée au niveau d'un côté intérieur du second corps (120), et la fiche (122) est insérée dans la prise (112) de sorte que le premier corps (110) et le second corps (120) sont connectés électriquement.

7. Dispositif électronique, comprenant la structure de dissipation de chaleur selon l'une quelconque des revendications 1 à 6.
